(19) **Europäisches Patentamt / European Patent Office / Office européen des brevets**

(11) **EP 4 512 928 A1**

(12) # EUROPEAN PATENT APPLICATION

(43) Date of publication:
26.02.2025 Bulletin 2025/09

(21) Application number: 23192670.0

(22) Date of filing: 22.08.2023

(51) International Patent Classification (IPC):
**C23C 28/04** (2006.01)   **C23C 28/00** (2006.01)
**C23C 30/00** (2006.01)

(52) Cooperative Patent Classification (CPC):
**C23C 28/42; C23C 14/0664; C23C 14/325; C23C 28/044; C23C 28/44; C23C 30/005;**
C23C 14/0641

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: WALTER AG
72072 Tübingen (DE)

(72) Inventors:
• **Schier, Veit**
  **72072 Tübingen (DE)**
• **Engelhart, Wolfgang**
  **72072 Tübingen (DE)**

(74) Representative: **Sandvik**
**Sandvik Intellectual Property AB**
**811 81 Sandviken (SE)**

(54) **A COATED CUTTING TOOL**

(57) The invention relates to a coated cutting tool (1) consisting of a substrate body (5) and a coating (6), the coating (6) comprises, in the order from the substrate body (5) surface, an inner layer of (Ti,Al)N (7) with an average composition $(Ti_{1-v}A_v)N$, $0.35 \leq v \leq 0.75$, a layer of (Ti,Si)N (8), being $Ti_{1-b}Si_bN$, $0.05 \leq b \leq 0.25$, a set of alternating (Ti,Al)N layers (9) and (Ti,Si)N layers (10), wherein each of the (Ti,Al)N layers (9) has an average composition $(Ti_{1-x}Al_x)N$, $0.35 \leq x \leq 0.75$ and each of the (Ti,Si)N layers (9) has a composition $Ti_{1-y}Si_yN$, $0.05 \leq y \leq 0.25$, an outer layer of (Ti,Al)N (11) with an average composition $(Ti_{1-c}Al_c)N$, $0.35 \leq c \leq 0.75$, on top of the set of alternating (Ti,Al)N layers (9) and (Ti,Si)N layers (10).

FIG. 3

EP 4 512 928 A1

## Description

The present invention relates to a coated cutting tool comprising a substrate body of cemented carbide and a wear resistant coating deposited on the substrate body.

## Background

Cutting tools for metal cutting, commonly consist of a substrate body made of cemented carbide having a wear-resistant coating of a combination of different layers deposited thereon by means of a CVD process (chemical vapor deposition) or a PVD process (physical vapor deposition). A cutting tool in this respect generally has a rake face, a flank face and a cutting edge in between. There exist various different types of PVD processes resulting in different coating properties, such as for example cathode sputtering, cathodic vacuum arc evaporation, and ion plating. Cathode sputtering such as magnetron sputtering, reactive magnetron sputtering and high power impulse magnetron sputtering (HIPIMS) and the arc evaporation belong to the PVD processes most frequently used for the coating of cutting tools.

The shape and geometry of the cutting tool depends on the intended metal cutting operation. Examples of cutting tools are milling inserts, turning inserts, drills, and endmills. Within the group of turning inserts there are as well parting inserts and grooving inserts.

Different wear processes on the tool eventually deteriorates the performance of the tool and it has to be changed to a new one. Thus, when preparing a coated cutting tool for metal cutting, a major goal is that the tool should perform in service as long as possible, i.e., the tool life should be as long as possible. Also, high cutting speeds should be possible to use in the cutting operation. Since high cutting speeds generate a lot of heat this means that, for example, the heat resistance of the cutting tool, in particular the coating, should be high. This is in particular of high importance for coated cutting tool inserts for parting and grooving since these cutting processes generate very high temperatures.

## Object of the invention

It is an object of the present invention to provide a coated cutting tool which generally has high wear resistance giving long tool life in metal machining such as milling, turning and drilling.

## The invention

The present invention relates to a coated cutting tool consisting of a substrate body and a coating, the coating comprises, in the order from the substrate body surface,

an inner layer of (Ti,Al)N with an average composition $(Ti_{1-v}A_v)N$, $0.35 \leq v \leq 0.75$, wherein

- the thickness of the inner layer of (Ti,Al)N is from 0.5 to 5 $\mu$m,

a layer of (Ti,Si)N, being $Ti_{1-b}Si_bN$, $0.05 \leq b \leq 0.25$, wherein

- the thickness of the layer of $Ti_{1-b}Si_bN$ is from 300 nm to 1.5 $\mu$m,

a set of alternating (Ti,Al)N layers and (Ti,Si)N layers, wherein

- each of the (Ti,Al)N layers has an average composition $(Ti_{1-x}Al_x)N$, $0.35 \leq x \leq 0.75$, and each of the (Ti,Si)N layers has a composition $Ti_{1-y}Si_yN$, $0.05 \leq y \leq 0.25$,
- the number each of (Ti,Al)N layers and (Ti,Si)N layers is $\geq 2$,
- the thickness of each of the (Ti,Al)N layers is from 125 to 250 nm,
- the thickness of each of the (Ti,Si)N layers is from 100 to 200 nm,
- the total thickness of the set of alternating (Ti,Al)N layers and (Ti,Si)N layers is from 0.45 to 2.5 $\mu$m,
- an outer layer of (Ti,Al)N with an average composition $(Ti_{1-c}Al_c)N$, $0.35 \leq c \leq 0.75$, most preferably $0.55 \leq c \leq 0.65$, on top of the set of alternating (Ti,Al)N layers and (Ti,Si)N layers, the thickness of this outer layer of (Ti,Al)N is from 250 nm to 2 $\mu$m.

The inner layer of (Ti,Al)N suitably has an average composition $(Ti_{1-v}Al_v)N$, $0.45 \leq v \leq 0.67$, preferably $0.55 \leq v \leq 0.65$.

The thickness of the inner layer of (Ti,Al)N is suitably from 1 to 5 $\mu$m, preferably from 2 to 4 $\mu$m.

The inner layer of (Ti,Al)N can either be present as a (Ti,Al)N monolayer or as a (Ti,Al)N nano-multilayer of

alternating (Ti,Al)N sub-layers.

In one embodiment, the inner layer of (Ti,Al)N is a first (Ti,Al)N nano-multilayer of alternating (Ti,Al)N sub-layers, wherein

- each of the individual (Ti,Al)N sub-layers within the first (Ti,Al)N nano-multilayer has a thickness of from 1 to 25 nm;
- each of the individual (Ti,Al)N sub-layers within the first (Ti,Al)N nano-multilayer being different in respect of the atomic ratio Ti:Al than an immediately adjacent (Ti,Al)N sub-layer.

The first (Ti,Al)N nano-multilayer of alternating (Ti,Al)N sub-layers, is suitably a nano-multilayer of one sub-layer $(Ti_{1-w}Al_w)N$, $0.40 \leq w \leq 0.80$, preferably $0.50 \leq w \leq 0.75$, most preferably $0.60 \leq w \leq 0.70$ and one sub-layer $(Ti_{1-a}Al_a)N$, $0.20 \leq a \leq 0.65$, preferably $0.35 \leq a \leq 0.60$, most preferably $0.45 \leq a \leq 0.55$, the Al content in the sub-layer $(Ti_{1-w}Al_w)N$ is higher than the Al content in the sub-layer $(Ti_{1-a}Al_a)N$.

When the individual (Ti,Al)N sub-layers of the first (Ti,Al)N nano-multilayer are very thin there may not be a sharp boundary between two adjacent sub-layers of different Ti:Al ratio. Instead, there may be a gradual change in the Ti:Al ratio over the thickness of the (Ti,Al)N nano-multilayer in a periodic manner. Due to this the Ti:Al ratio of a sub-layer is herein considered to be the Ti:Al ratio present in the middle of a sub-layer.

In one embodiment, the first (Ti,Al)N nano-multilayer comprises two or more (Ti,Al)N sub-layer stacks arranged immediately on top of each other, wherein within the same (Ti,Al)N sub-layer stack there exists at least two types of individual (Ti,Al)N sub-layers wherein the at least two types of individual (Ti,Al)N sub-layers have different Ti:Al atomic ratios, the overall Al content within each of the (Ti,Al)N sub-layer stacks increases from one (Ti,Al)N sub-layer stack to the next (Ti,Al)N sub-layer stack in the direction towards the outer surface of the coating.

Preferably, the increase in the overall Al content within each of the (Ti,Al)N sub-layer stacks from one (Ti,Al)N sub-layer stack to the next (Ti,Al)N sub-layer stack in the direction towards the outer surface of the coating of the first (Ti,Al)N nano-multilayer includes that the atomic ratio Ti:Al over several pairs of adjacent (Ti,Al)N sub-layers remains constant over several pairs of adjacent (Ti,Al)N sub-layers of one sub-layer stack and then the atomic ratio Ti:Al is lowered by a significant amount in the next several pairs of adjacent (Ti,Al)N sub-layers of a further sub-layer stack.

The difference in the overall Al content between the (Ti,Al)N sub-layer stacks, can be achieved in several ways, individually or in combination. For example, an increase of the Al content can be achieved by the selection of the types and number of targets containing certain amounts of Al and Ti during the progress of the deposition process. Further, the Al and Ti contents in the deposited coating layers can be varied by varying the deposition condition, such as bias and arc current.

Also, the increase of the Al content over the thickness of the second (Ti,Al)N nano-multilayer can be achieved by an increase of the thicknesses of the individual (Ti,Al)N sub-layers having higher Al contents than the thicknesses of the individual (Ti,Al)N sub-layers having lower Al contents.

An increase of the Al content over the thickness of the first (Ti,Al)N nano-multilayer may lead to different residual stresses between parts of the first (Ti,Al)N nano-multilayer. Also, the residual stress within the first (Ti,Al)N nano-multilayer can be influenced by varying the deposition condition, such as bias and arc current.

Within the same (Ti,Al)N sub-layer stack of the first (Ti,Al)N nano-multilayer there exists suitably from two to five, preferably from two to four, most preferably two, types of individual (Ti,Al)N sub-layers wherein the different types of individual (Ti,Al)N sub-layers have different Ti:Al atomic ratios.

Suitably, each of the individual (Ti,Al)N sub-layers within the first (Ti,Al)N nano-multilayers of alternating (Ti,Al)N sub-layers has a thickness of from 2 to 20 nm, preferably from 3 to 10 nm.

In one embodiment, the thickness of each (Ti,Al)N sub-layer stack of the first (Ti,Al)N nano-multilayer is from 0.5 to 5 $\mu$m, suitably 1 to 3.5 $\mu$m, preferably from 1 to 2.5 $\mu$m.

Suitably, the first (Ti,Al)N nano-multilayer consists of from two to five, preferably two to three, most preferably two (Ti,Al)N sub-layer stacks, arranged immediately on top of each other.

In one embodiment of the present invention, the inner layer of (Ti,Al)N is an innermost layer deposited immediately to the substrate surface, i.e., the inner layer of (Ti,Al)N is in direct contact and has an interface with the substrate surface.

In one embodiment there is an innermost layer of a nitride of one or more of Ti and Cr, or a nitride of one or more of Ti and Cr, in combination with Al, such as (Ti,Al)N, deposited immediately to the substrate surface, followed by the inner layer of (Ti,Al)N. This innermost layer has a function as increasing coating adhesion. The innermost layer has a thickness of from 5 to 100 nm, or from 10 to 50 nm.

In the layer of $Ti_{1-b}Si_bN$, suitably $0.10 \leq b \leq 0.20$. The thickness of the layer of $Ti_{1-b}Si_bN$ is suitably from 500 nm to 1.2 $\mu$m.

The number each of (Ti,Al)N layers and (Ti,Si)N layers within the set of alternating (Ti,Al)N layers and (Ti,Si)N layers is suitably from 2 to 10, preferably from 2 to 7, most preferably from 2 to 4. When using a higher number, i.e., a higher number of repetitions, more toughness is introduced into the coating and it is also believed that a lower thermoconductivity is provided due to the increased number of grain boundaries. However, if the number is too high, the overall thickness of the set of alternating (Ti,Al)N layers and (Ti,Si)N layers may be too thick for an optimal result. Therefore, it is preferred to limit the number of repetitions so that an optimal technical effect is provided.

Within the set of alternating (Ti,Al)N layers and (Ti,Si)N layers, each of the (Ti,Al)N layers has an average composition $(Ti_{1-x}Al_x)N$, of suitably $0.45 \leq x \leq 0.67$, preferably $0.55 \leq x \leq 0.65$.

Within the set of alternating (Ti,Al)N layers and (Ti,Si)N layers, the (Ti,Si)N layers are $Ti_{1-y}Si_yN$ layers, suitably $0.10 \leq y \leq 0.20$.

Within the set of alternating (Ti,Al)N layers and (Ti,Si)N layers, the thickness of each of the (Ti,Al)N layers is suitably from 135 to 200 nm.

Within the set of alternating (Ti,Al)N layers and (Ti,Si)N layers, the thickness of each of the (Ti,Si)N layers is suitably from 125 to 175 nm.

The total thickness of the set of alternating (Ti,Al)N layers and (Ti,Si)N layers is suitably from 0.5 to 1.75 $\mu$m, preferably from 0.55 to 1 $\mu$m.

The (Ti,Al)N layers within the set of alternating (Ti,Al)N layers and (Ti,Si)N layers, can either be present as (Ti,Al)N monolayers or as (Ti,Al)N nano-multilayers of alternating (Ti,Al)N sub-layers.

In one embodiment, the (Ti,Al)N layers within the set of alternating (Ti,Al)N layers and (Ti,Si)N layers are each a second (Ti,Al)N nano-multilayer of alternating (Ti,Al)N sub-layers, wherein

- each of the individual (Ti,Al)N sub-layers within the second (Ti,Al)N nano-multilayer has a thickness of from 1 to 25 nm;
- each of the individual (Ti,Al)N sub-layers within the second (Ti,Al)N nano-multilayer being different in respect of the atomic ratio Ti:Al than an immediately adjacent (Ti,Al)N sub-layer.

The second (Ti,Al)N nano-multilayer of alternating (Ti,Al)N sub-layers, is suitably a nano-multilayer of one sub-layer $(Ti_{1-z}Al_z)N$, $0.40 \leq z \leq 0.80$, preferably $0.50 \leq z \leq 0.75$, most preferably $0.60 \leq z \leq 0.70$ and one sub-layer $(Ti_{1-u}Al_u)N$, $0.20 \leq u \leq 0.65$, preferably $0.35 \leq u \leq 0.60$, most preferably $0.45 \leq u \leq 0.55$, the Al content in the sub-layer $(Ti_{1-z}Al_z)N$ is higher than the Al content in the sub-layer $(Ti_{1-u}Al_u)N$.

When the individual (Ti,Al)N sub-layers of the second (Ti,Al)N nano-multilayer are very thin there may not be a sharp boundary between two adjacent sub-layers of different Ti:Al ratio. Instead, there may be a gradual change in the Ti:Al ratio over the thickness of the second (Ti,Al)N nano-multilayer in a periodic manner. Due to this the Ti:Al ratio of a sub-layer is herein considered to be the Ti:Al ratio present in the middle of a sub-layer.

In one embodiment, within the same (Ti,Al)N sub-layer stack of the second (Ti,Al)N nano-multilayer there exists from two to five, preferably from two to three, most preferably two, different types of individual (Ti,Al)N sub-layers, the (Ti,Al)N sub-layers of the same type having the same composition with respect to the Ti:Al atomic ratio, and wherein the different types of individual (Ti,Al)N sub-layers have different Ti:Al atomic ratios.

Suitably, each of the individual (Ti,Al)N sub-layers within the second (Ti,Al)N nano-multilayer of alternating (Ti,Al)N sub-layers has a thickness of from 2 to 20 nm, preferably from 3 to 10 nm.

In one embodiment the second (Ti,Al)N nano-multilayer in the (Ti,Al)N within the set of alternating (Ti,Al)N layers and (Ti,Si)N layers has the same sub-layer alternation and sub-layer compositions as present in the outermost sub-layer stack of the (Ti,Al)N sub-layer stacks of the first (Ti,Al)N nano-multilayer. The reasons for this are both practical and technical. there is an advantage in keeping the comparatively higher aluminium content of the outermost sub-layer stack of the first (Ti,Al)N nano-multilayer since it has been shown that a higher aluminium content correlates to better wear resistance. Also, in case the aluminium content has been increased in the inner layer of (Ti,Al)N by adding a further target of the higher aluminium content in the PVD chamber then the deposition rate increases which is an advantage.

The outer layer of (Ti,Al)N suitably has an average composition $(Ti_{1-c}Al_c)N$, $0.45 \leq c \leq 0.67$, preferably $0.55 \leq c \leq 0.65$. The thickness of this outer layer of (Ti,Al)N is suitably from 300 nm to 1 $\mu$m.

The outer layer of (Ti,Al)N is suitably a third (Ti,Al)N nano-multilayer of alternating (Ti,Al)N sub-layers, wherein

- each of the individual (Ti,Al)N sub-layers within the third (Ti,Al)N nano-multilayer has a thickness of from 1 to 25 nm;
- each of the individual (Ti,Al)N sub-layers within the third (Ti,Al)N nano-multilayer being different in respect of the atomic ratio Ti:Al than an immediately adjacent (Ti,Al)N sub-layer.

The outer layer of (Ti,Al)N being a third (Ti,Al)N nano-multilayer of alternating (Ti,Al)N sub-layers, is suitably a nano-multilayer of one sub-layer $(Ti_{1-d}Al_d)N$, $0.40 \leq d \leq 0.80$, preferably $0.50 \leq d \leq 0.75$, most preferably $0.60 \leq d \leq 0.70$ and one sub-layer $(Ti_{1-e}Al_e)N$, $0.20 \leq e \leq 0.65$, preferably $0.35 \leq e \leq 0.60$, most preferably $0.45 \leq e \leq 0.55$, the Al content in the sub-layer $(Ti_{1-d}Al_d)N$ is higher than the Al content in the sub-layer $(Ti_{1-e}Al_e)N$.

In one embodiment, there is a transition region between each of the (Ti,Al)N layers and the (Ti,Si)N layers in the set of alternating (Ti,Al)N layers and (Ti,Si)N layers, which has a thickness of less than 25 nm, or from 1 to 20 nm, or from 3 to 15 nm, the transition region comprises a solid solution phase of (Ti,Al,Si)N, the average content of Ti within the transition region is from 85 to 93 at%, the average content of Al within the transition region is from 3 to 10 at%, and the average content of Si within the transition region is from 2 to 12 at%, out of the total of the elements Ti, Al and Si.

This transition region comprising a solid solution phase of (Ti,Al,Si)N should be as thin as possible since the solid solution phase is considered to weaken the coating. The presence of a solid solution phase can be determined by XRD analysis. The thickness of a transition region comprising a solid solution phase can be determined by transmission electron microscopy (TEM) imaging, suitably in combination with electron energy loss spectroscopy (EELS) analysis.

In one embodiment there are crystal lattice planes going through the whole of the (Ti,Si)N layers in the set of alternating (Ti,Al)N layers and (Ti,Si)N layers. This can be determined by TEM analysis. Thus, the (Ti,Si)N in the (Ti,Si)N layers is present as a crystalline phase and not as a classical nano-composite with crystalline TiN within an amorphous $Si_3N_4$ matrix.

The mechanical properties of the coating of the invention are surprisingly excellent with high hardness and high plane strain modulus.

In one embodiment, the coating has a Vickers hardness of > 3000 HV0.0015, or > 3100 HV0.0015 but < 3800 HV0.0015, or > 3200 HV0.0015 but < 3600 HV0.0015.

In one embodiment, the coating has a plane strain modulus of > 475 GPa, suitably > 485 GPa but < 530 GPa, preferably > 495 GPa but < 520 GPa.

The residual compressive stress of (Ti,Si)N layers within the coating of the invention should be quite low. Within the coating there is in one embodiment a residual compressive stress, as measured by X-ray diffraction applying the $sin^2\Psi$ method based on the (1 1 1) reflection of (Ti,Si)N, of > 1 GPa but < 3 GPa, suitably > 1.3 GPa but < 2.5 GPa, preferably > 1.5 GPa but < 2 GPa. The value obtained of residual compressive stress, as measured by X-ray diffraction applying the $sin^2\Psi$ method based on the (1 1 1) reflection of (Ti,Si)N will result from the residual stress in the (Ti,Si)N layers in set of alternating (Ti,Al)N layers and (Ti,Si)N layers as well as result from the residual stress in any possible further (Ti,Si)N layer present within the coating. If there is any additional coating material above the set of alternating (Ti,Al)N layers and (Ti,Si)N layers the additional coating material should be removed before the measuring. Care has to be taken to select and apply a method for the removal of material which does not significantly alter the residual stress within the remaining layers to be measured. A suitable method for the removal of deposited coating material may be polishing, however, gentle and slow polishing using a fine-grained polishing agent should be applied. Strong polishing using a coarse grained polishing agent will rather increase the compressive residual stress, as it is known in the art. Other suitable methods for the removal of deposited coating material are ion etching and laser ablation.

In one embodiment, the coating comprises as an outermost layer a metal nitride layer, the metal is one or more elements belonging to group 4, 5, or 6, of the periodic table of elements, preferably Zr, Ti, and Cr, optionally together with Al and/or Si, the thickness being from 0.01 to 1 $\mu$m, preferably from 0.05 to 0.5 $\mu$m. As a preferred alternative (Ti,Si)N is used as an outermost layer. The function of this outermost layer is one or more of wear indication, decor, and diffusion barrier to workpiece materials which prevents adhesion of workpiece material.

The total thickness of the whole coating of the coated cutting tool is suitably from 3 to 10 $\mu$m, preferably from 4 to 8 $\mu$m. The ideal thickness depends, e.g., on the metal cutting application.

The substrate body is suitably of a cemented carbide, a cermet, a cubic boron nitride, a ceramic, or a high-speed steel, preferably a cemented carbide.

In a preferred embodiment, the substrate body of the coated cutting tool of the present invention is a WC-Co based cemented carbide comprising from 5 to 15 wt% Co. The substrate optionally comprises further cubic carbides or carbonitrides, as is generally known in the art.

In one embodiment, the substrate is a cemented carbide with a composition, balancing 100 wt%, of from 85 to 91 wt% WC, from 0.2 to 1 wt% Cr and from 10 to 14 wt% Co. The WC grain size is < 1 $\mu$m, preferably from 0.2 to 0.6 $\mu$m.

In one embodiment, the substrate is a cemented carbide with a composition, balancing 100 wt%, of from 88 to 92 wt% WC, from 0.5 to 2 wt% (Ta,Nb)C and from 6 to 10 wt% Co. The WC grain size is < 1.5 $\mu$m, preferably from 0.5 to 1.2 $\mu$m.

The WC grain size is herein determined from the value of magnetic coercivity. The relationship between coercivity and grain size of WC is described, e.g., in Roebuck et al., Measurement Good Practice No. 20, National Physical Laboratory, ISSN 1368-6550, November 1999, Revised February 2009, Section 3.4.3, pages 19-20. For the purposes of this application the grain size of the WC, d, is determined according to formula (8) on page 20 in the above-mentioned literature:

$$K = (c_1 + d_1 W_{Co}) + (c_2 + d_2 W_{Co})/d.$$

Re-arranging one gets:

$$d = (c_2 + d_2 W_{Co})/ (K - (c_1 + d_1 W_{Co})),$$

wherein d= WC grain size of the cemented carbide body, K= coercivity of the cemented carbide body in kA/m, herein measured according to standard DIN IEC 60404-7, $W_{Co}$ = wt% Co in the cemented carbide body, $c_1$ = 1.44, $c_2$ = 12.47, $d_1$ = 0.04, and $d_2$ = -0.37.

The cutting tool is suitably a cutting insert for milling, a cutting insert for turning, a cutting insert for drilling, a drill or an endmill. In a preferred embodiment, the cutting tool is a cutting insert for turning, in particular a cutting insert for parting and grooving.

The cutting tool suitably comprises a rake face and a flank face with a cutting edge in between.

In one embodiment, the coated cutting tool has been subjected to a wet blasting post-treatment procedure. By "wet blasting" is herein meant a blasting process using a media comprising abrasive particles, herein aluminium oxide, in a liquid forming a slurry, wherein material typically is removed to some extent leading to a smoother surface of the coating. This procedure is generally known in the art.

**Methods**

XRD (X-ray diffraction)

XRD measurements were done on a Malvern Panalytical B.V Empyrean using CuKa-radiation. The X-ray tube was run in point focus at 40 kV and 40 mA. A parallel beam optic using a mirror with a mask of 2mm and a 1/8 divergence slit in the vertical direction and 0.04° soller slit was used on the primary side whereby the irradiated area of the sample was defined in such manner that a spill over of the X-ray beam over the coated face of the sample is avoided. On the secondary side a parallel plate collimator with an acceptance angle 0.18° and a Ni $K_\beta$ filter were used. The measurements were carried out with a 2-theta step size of 0,05°. Grazing-incidence X-ray diffraction technique under 1° incidence angle was employed.

A solid solution phase gives rise to a pattern of peaks in an XRD diffractogram. The presence of a solid solution phase of (Ti,Al,Si)N within the set of alternating (Ti,Al)N layers and (Ti,Si)N layers can be established by applying curve fitting to, e.g., a combined peak containing information from (200) reflections from different solid solution phases present.

STEM analysis + EDX + EELS

The analysis of the set of alternating (Ti,Al)N layers and (Ti,Si)N layers in order to verify the changes in composition and crystal structure through the whole layer was made by scanning transmission electron microscopy (STEM) analysis in combination with energy-dispersive X-ray spectroscopy (EDX) and also electron energy loss spectroscopy (EELS).

The content of metal elements can be measured by using STEM with EDX on a cross sectional FIB-prepared sample. For TEM imaging and EDX analysis used in the analysis within this disclosure, Jeol ARM System instrument was used, equipped with a field emission gun, secondary electron-dectector and Si(Li) energy dispersive x-ray (EDX) detector from Oxford Instruments. One can either using a spot size small enough for probing, or use STEM mode to get an elemental mapping over a distance in the coating.

In a STEM image it was selected a rectangular area in the direction of the coating plane. The height of the rectangular area was selected to be 1.5 to 3 nm. The length of the rectangular area was selected to be at least 100 nm, for example 100 to 200 nm. The rectanglar area was placed within either a (Ti,Al)N sub-layer or a (Ti,Al)N sub-layer in the set of alternating (Ti,Al)N layers and (Ti,Si)N layers. EDX data and EELS data are retrieved from the rectangular area. Then the rectangular area is moved one step down in the coating with a distance corresponding to the height of the rectangular area. Further EDX and EELS data are retrieved. The procedure is repeated so that data from a whole (Ti,Al)N-(Ti,Si)N period is retrieved. EDX data reveals if all of Ti, Al and Si are present within a certain rectangular area in an intermediate region between pure (Ti,Al)N and pure (Ti,Si)N. Analysis of the changes in the shape of the N-K EELS edge when comparing a number of consecutive rectangular areas identifies the presence of a solid solution (Ti,Al,Si)N between pure (Ti,Al)N and (Ti,Si)N and the thickness of the solid solution region. Also, a cubic crystal structure may be possible to derive from the EELS data.

Residual stress

The residual stresses were measured by XRD using the $\sin^2\Psi$ method (c.f. M.E. Fitzpatrick, A.T. Fry, P. Holdway, F.A. Kandil, J. Shackleton and L. Suominen - A Measurement Good Practice Guide No. 52; "Determination of Residual Stresses by X-ray Diffraction - Issue 2", 2005) .

The side-inclination method ($\Psi$-geometry) has been used with eight $\Psi$-angles, equidistant within a selected $\sin^2\Psi$ range. An equidistant distribution of $\Phi$-angles wihin a $\Phi$-sector of 90° is preferred. The measurement was performed on a rake side of the tool, i.e. using an as flat surface as possible. For the calculations of the residual stress values, the Poisson's ratio = 0.20 and the Young's modulus E = 450 GPa have been applied. For measurements on a (Ti,Al)N layer the

data were evaluated using commercially available software (RayfleX Version 2.503) locating the (1 1 1) reflection of (Ti,Si) N by the Pseudo-Voigt-Fit function. Depending on the diffraction pattern also other reflections are possible, such as the (2 0 0) reflection, provided there is a sufficient signal strength.

For measurements of residual stress of a layer of a coating having further deposited layers above itself coating material is removed above the layer to be measured. Care has to be taken to select and apply a method for the removal of material which does not significantly alter the residual stress within the remaining coating. A suitable method for the removal of deposited coating material may be polishing, however, gentle and slow polishing using a fine-grained polishing agent should be applied. Strong polishing using a coarse grained polishing agent will rather increase the compressive residual stress, as it is known in the art. Other suitable methods for the removal of deposited coating material are ion etching and laser ablation.

Vickers hardness and plane strain modulus:

The Vickers hardness was measured by means of nano indentation (load-depth graph) using a Picodentor HM500 of Helmut Fischer GmbH, Sindelfingen, Germany. For the measurement and calculation the Oliver and Pharr evaluation algorithm was applied, wherein a diamond test body according to Vickers was pressed into the layer and the force-path curve was recorded during the measurement. The maximum load used was 15 mN (HV 0.0015), the time period for load increase and load decrease was 20 seconds each. From this curve hardness was calculated.

The elastic properties of the coating samples were characterized by the so-called plane strain modulus $E_{ps}$ as derived by nanoindentation via the Oliver and Pharr method. The nano-indentation data was obtained from indentation as described for Vickers hardness above.

**Brief description of drawings**

Figure 1 shows a schematic view of one embodiment of a cutting tool being one type of turning insert.
Figure 2 shows a schematic view of one embodiment of a cutting tool being one type of turning insert.
Figure 3 shows a schematic view of a cross section of an embodiment of the coated cutting tool of the present invention showing a substrate and a coating comprising different layers.

**Detailed description of embodiments in drawings**

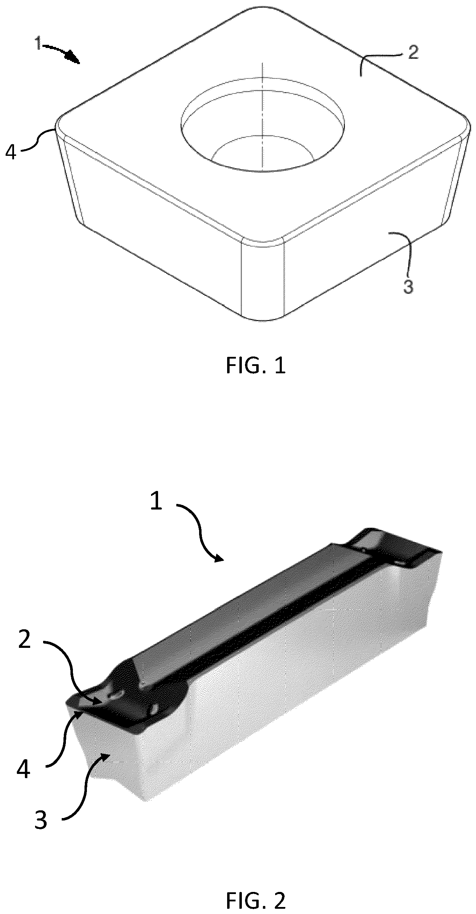

Figure 1 shows a schematic view of one embodiment of a cutting tool (1) having a rake face (2) and flank faces (3) and a cutting edge (4). The cutting tool (1) is in this embodiment a turning insert.

Figure 2 shows a schematic view of one embodiment of a cutting tool (1) having a rake face (2) and flank faces (3) and a cutting edge (4). The cutting tool (1) is in this embodiment a turning insert specifically for parting and grooving operations of a so called "GX" geometry.

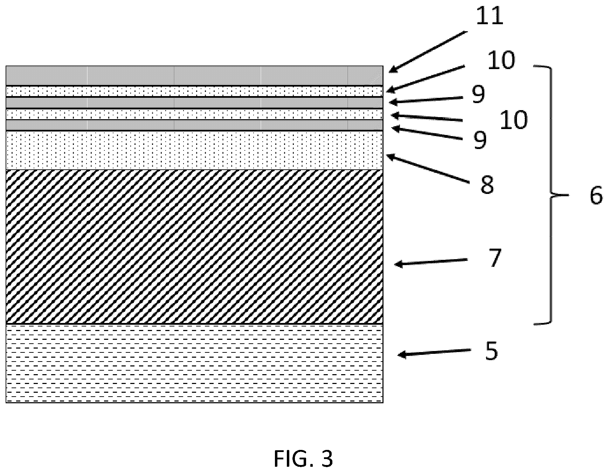

Figure 3 shows a schematic view of a cross section of an embodiment of the coated cutting tool of the present invention having a substrate body (5) and a coating (6). The coating comprising an inner (Ti,Al)N layer (7), a (Ti,Si)N layer (8), a set of alternating (Ti,Al)N layers (9) and (Ti,Si)N layers (10) and an outer (Ti,Al)N layer (11).

**Examples**

**Example** 1: **Manufacturing of "Sample 1 (invention)"**

As a substrate was used cutting tool bodies (called "blanks") being inserts having a geometry GX24-2E300N02-CE4 (parting and grooving insert), SPHT120408 (milling insert), and flat inserts for analysis of coating.

The cutting tool body was for the geometry SPHT120408 made out of a cemented carbide of the composition 90.6 wt% WC, 1.4 wt% (Ta, Nb)C and a binder phase of 8 wt% Co. The average WC grain size dWC was 0.8 $\mu$m.

The cutting tool body was for the geometry GX24-2E300N02-CE4 made out of a cemented carbide of the composition 87.5 wt% WC, and a binder phase of 12 wt% Co and 0.5 wt% Cr. The average WC grain size dWC was 0.5 $\mu$m.

The cutting tool body was for the flat inserts for analysis made out of a cemented carbide of the composition 94 wt% WC, and a binder phase of 6 wt% Co.

Prior to the deposition, the substrate bodies were pretreated by ultrasonic cleaning in a water-based medium.

The PVD reactor was evacuated to $8 \times 10^{-5}$ mbar, and the substrate was pre-treated at 550°C. The pre-treatment included an Ar ion etching procedure.

The coating equipment used for depositing the coating according to the invention was a Hauzer HTC1000 (IHI Hauzer Techno Coating B.V., The Netherlands) with a chamber size of 1 m$^3$.

An innermost Ti$_{0.50}$Al$_{0.50}$N adhesion layer was at first deposited to a thickness of about 10-20 nm. In the deposition cathodic arc evaporation was used. In the Hauzer HTC1000 equipment used a circular Arc-PVD technology (CARC+) using constant magnetic field configuration was applied during deposition. A TiAl-target "Ti50Al50" (Ti:Al = 50:50) was used. The target had a diameter of 100 mm. The reactive gas for the nitride deposition was N$_2$. The deposition was carried out at an arc current at the target of about 150 A, a bias level of -40 V and at a N$_2$ pressure of 10 Pa. The temperature during the deposition was about 550°C. A table rotation speed of 3 rpm was used.

Deposition of an inner (Ti,Al)N nano-multilayer:

Then, an inner (Ti,Al)N layer being a (Ti,Al)N nano-multilayer was deposited. In the deposition of the inner (Ti,Al)N nano-multilayer cathodic arc evaporation was used. In the Hauzer HTC1000 equipment used a circular Arc-PVD technology (CARC+) using constant magnetic field configuration was applied during deposition.

For the deposition of the inner (Ti,Al)N nano-multilayer, two types of TiAl-targets with different atomic ratios Ti:Al were used to produce alternating (Ti,Al)N sub-layers. The Ti:Al atomic ratios in the two types of TiAl-targets, respectively, were "Ti50Al50" (Ti:Al = 50:50) and "Ti33Al67" (Ti:Al = 33:67).

If reference is herein made to a target of a particular composition, this means that, due to the layout of the used PVD reactor, a line of four targets of the same composition were vertically arranged to allow for a homogeneous deposition throughout the height of the reactor.

The targets had a diameter of 100 mm. The reactive gas for the nitride deposition was N$_2$. Two types of (Ti,Al)N sub-layer stacks, L1 and L2, were produced. To produce the coating, L1 was deposited immediately on the substrate surface, and L2 was deposited immediately on top of L1. For the deposition of L1, two targets were used: 1x "Ti50Al50" + 1x "Ti33Al67". To achieve a lower Ti content and a higher Al content in L2, for the deposition of L2 three targets were used: 1x "Ti50Al50" + 2x "Ti33Al67". The deposition was carried out at an arc current at the target of about 150 A, a bias level of -40 V and at a N$_2$ pressure of 10 Pa. The further process parameters for the deposition are given in table 1.

Table 1.

| (Ti,Al)N sub-layer stack L1 | Targets | "Ti50Al50" + "Ti33Al67" |
| --- | --- | --- |
| | Bias | -40 V |
| | Pressure (N$_2$) | 10 Pa |
| | Arc Current / Target | 150 A |
| | Rotation Speed | 3 rpm |
| | Temperature | 550 °C |
| (Ti,Al)N sub-layer stack L2 | Targets | "Ti33Al67" + "Ti50Al50" + "Ti33Al67" |
| | Bias | -40 V |
| | Arc Current / Target | 150 A |
| | Pressure | 10 Pa |
| | Rotation | 3 rpm |
| | Temperature | 550 °C |

The thicknesses of the sub-layer stacks L1 and L2 were about 1.7 $\mu$m each, measured at the edge (at the beginning of the edge rounding) on both the rake face and the flank face and calculating an average.

The deposition time for L1 was 90 minutes when depositing using -40 V (samples S1, S3 and S5). Thus, L1 consisted of about 270 sub-layer periods, approximating an individual sub-layer thickness of about 4 nm.

The deposition time for L2 was 60 minutes when depositing using -40 V (samples S1, S3 and S5). Thus, L2 consisted of about 180 sub-layer periods, approximating an individual sub-layer thickness of about 4 nm for the sub-layer having an approximate composition Ti$_{0.50}$Al$_{0.50}$N and an individual sub-layer thickness of about 8 nm for the sub-layer having an approximate composition Ti$_{0.33}$Al$_{0.67}$N.

The average composition for the inner (Ti,Al)N layer being a (Ti,Al)N nano-multilayer was Ti$_{0.40}$Al$_{0.60}$N.

Deposition of a (Ti,Si)N layer:

Furthermore, a (Ti,Si)N layer was provided onto the combination of (Ti,Al)N sub-layer stacks L1/L2. In the Hauzer HTC1000 equipment it was still used a circular Arc-PVD technology (CARC+) using constant magnetic field configuration applied during deposition.

A TiSi-target "Ti85Si15" (Ti:Si = 85:15) was used. The target had a diameter of 100 mm. The reactive gas for the nitride deposition was $N_2$. The deposition was carried out at an arc current at the target of about 150 A, a bias level of -40 V and at a $N_2$ pressure of 10 Pa. The temperature during the deposition was about 550°C. A table rotation speed of 3 rpm was used.

0.8 $\mu$m of $Ti_{0.85}Si_{0.15}N$ was deposited onto the sample.

Deposition of a set of alternating (Ti,Al)N layers and (Ti,Si)N layers:

The sample was further deposited with a set of alternating (Ti,Al)N layers and (Ti,Si)N layers. The (Ti,Al)N layers having an average composition $Ti_{0.39}Al_{0.61}N$ and the (Ti,Si)N layers being $Ti_{0.85}Si_{0.15}N$. The (Ti,Al)N layers being (Ti,Al)N nano-multilayers.

There were two (Ti,Al)N nano-multilayers and two (Ti,Si)N layers deposited so the layer sequence is (Ti,Al)N - (Ti,Si)N - (Ti,Al)N - (Ti,Si)N.

The thickness of each of the Ti,Al)N nano-multilayers were about 150 nm and each of the (Ti,Si)N layers were about 150 nm. The thicknesses determined by scanning electron microscopy (SEM) analysis.

The (Ti,Al)N nano-multilayers are deposited in the same manner as when depositing the sub-layer stack L2 of the previous inner (Ti,Al)N nano-multilayer for the sample, i.e., in the Hauzer HTC1000 equipment used a circular Arc-PVD technology (CARC+) using constant magnetic field configuration was applied during deposition. All other parameters and process conditions were the same as used for making the sub-layer stack L2 of the previously deposited (Ti,Al)N nano-multilayer. For the deposition of the (Ti,Al)N nano-multilayers of the set of alternating (Ti,Al)N layers and (Ti,Si)N layers, as for depositing L2 of the previously deposited (Ti,Al)N nano-multilayer, three targets were used: 1x "Ti50Al50" + 2x "Ti33Al67". The process parameters are summarised in table 2.

Table 2.

| (Ti,Al)N nano-multilayer of the set of alternating (Ti,Al)N layers and (Ti,Si)N layers | Targets | "Ti33Al67" + "Ti50Al50" + "Ti33Al67" |
| --- | --- | --- |
| | Bias | -40 V |
| | Arc Current / Target | 150 A |
| | Pressure | 10 Pa |
| | Rotation | 3 rpm |
| | Temperature | 550 °C |

The deposition time for each (Ti,Al)N nano-multilayer was about 200 s which can be estimated to give a layer thickness of a (Ti,Al)N nano-multilayer to be 0.11 $\mu$m. Since the number of sub-layer periods is about 10 for 200 s deposition, an individual sub-layer thickness is approximated to about 4 nm for the sub-layer having an approximate composition $Ti_{0.50}Al_{0.50}N$ and an individual sub-layer thickness of about 8 nm for the sub-layer having an approximate composition $Ti_{0.33}Al_{0.67}N$.

The average composition for each (Ti,Al)N nano-multilayer was $Ti_{0.39}Al_{0.61}N$.

The (Ti,Si)N layers of the set of alternating (Ti,Al)N layers and (Ti,Si)N layers were deposited by Arc-PVD using the same parameters and conditions as for depositing the previously deposited (Ti,Si)N layer.

Deposition of an outer (Ti,Al)N nano-multilayer:

Then, an outer (Ti,Al)N layer being a (Ti,Al)N nano-multilayer was deposited. The (Ti,Al)N nano-multilayers was deposited in the same manner as when depositing the sub-layer stack L2 of the previous (Ti,Al)N nano-multilayer for the sample, i.e., in the Hauzer HTC1000 equipment used a circular Arc-PVD technology (CARC+) using constant magnetic field configuration was applied during deposition. All other parameters and process conditions were the same as used for making the sub-layer stack L2 of the previously deposited inner (Ti,Al)N nano-multilayer, as well as the same sub-layer stack present in the (Ti,Al)N layers of the set of alternating (Ti,Al)N layers and (Ti,Si)N layers. The thickness of the deposited outer (Ti,Al)N nano-multilayer was about 0.4 $\mu$m.

Thus, the total thickness of the whole coating on the sample was about 5.2 $\mu$m.

The layer structure provided is seen in table 3.

Table 3.

| Layer # (from substrate) | Layer Thickness | Layer | (Ti,Al)N sublayer composition |
|---|---|---|---|
| 1 | 3.4 $\mu$m (1.7 $\mu$m L1 + 1.7 $\mu$m L2) | inner (Ti,Al)N (nano-multilayer) | $Ti_{0.33}Al_{0.67}N$/ $Ti_{0.50}Al_{0.50}N$ (two different stacks L1 and L2) |
| 2 | 0.8 $\mu$m | (Ti,Si)N | - |
| 3 | 0.150 $\mu$m | second (Ti,Al)N nano-multilayer | $Ti_{0.33}Al_{0.67}N$/ $Ti_{0.50}Al_{0.50}N$ (as L2) |
| 4 | 0.150 $\mu$m | (Ti,Si)N | - |
| 5 | 0.150 $\mu$m | second (Ti,Al)N nano-multilayer | $Ti_{0.33}Al_{0.67}N$/ $Ti_{0.50}Al_{0.50}N$ (as L2) |
| 6 | 0.150 $\mu$m | (Ti,Si)N | - |
| 7 | 0.4 $\mu$m | outer (Ti,Al)N (nano-multilayer) | $Ti_{0.33}Al_{0.67}N$/ $Ti_{0.50}Al_{0.50}N$ (as L2) |

Post treatment operations

The sample was post treated by wet blasting using a slurry of aluminium oxide particles in water.

The wet blasting used a blasting gun from which the slurry exits a blasting nozzle. The blasting pressure is the exiting pressure from the nozzle. The concentration of aluminium oxide particles in the slurry was from 15 to 20 vol-%. For abrasive grains used in for example blasting there is a well-established standard - FEPA (Federation of European Producers of Abrasives) - defining the particle size. The blasting time in the wet blasting per insert was from 2 to 10 seconds.

Wet blasting parameters:

| | |
|---|---|
| Blasting pressure: | 1.6 to 2 bar |
| Blasting Angle: | 75°, against the surface plane of the coating |
| Blasting Distance: | 10 cm |
| Blasting Material: | $Al_2O_3$ F220 (FEPA) |

The sample made is denoted "Sample 1 - invention".

**Example 2: Manufacturing of "Sample 2 (comparative)"**

((Ti,Al)N/(Ti,Si)N nano-multilayer)

As a substrate was used cutting tool bodies (called "blanks") being inserts having a geometry SPHT120408 (milling insert), and flat inserts for analysis of coating.

The cutting tool body was for the geometry SPHT120408 made out of a cemented carbide of the composition 90.6 wt% WC, 1.4 wt% (Ta, Nb)C and a binder phase of 8 wt% Co. The average WC grain size dWC was 0.8 $\mu$m.

The cutting tool body was for the flat inserts for analysis made out of a cemented carbide of the composition 94 wt% WC, and a binder phase of 6 wt% Co.

Prior to the deposition, the substrate bodies were pretreated by ultrasonic cleaning in a water-based medium.

The PVD reactor was evacuated to $8 \times 10^{-5}$ mbar, and the substrate was pre-treated at 550°C. The pre-treatment included an Ar ion etching procedure.

The coating equipment used for depositing the coating according to the invention was a Hauzer HTC1000 (IHI Hauzer Techno Coating B.V., The Netherlands) with a chamber size of 1 m$^3$.

An innermost, about 10-20 nm, $Ti_{0.40}Al_{0.60}N$ adhesion layer was at first deposited. In the deposition cathodic arc evaporation was used. In the Hauzer HTC1000 equipment used a circular Arc-PVD technology (CARC+) using constant magnetic field configuration was applied during deposition. A TiAl-target "Ti40Al60" (Ti:Al = 40:60) was used. The target had a diameter of 100 mm. The reactive gas for the nitride deposition was $N_2$. The deposition was carried out at an arc current at the target of about 150 A, a bias level of -40 V and at a $N_2$ pressure of 10 Pa. The temperature during the deposition was about 550°C. A table rotation speed of 3 rpm was used.

Then, a (Ti,Al)N-(Ti,Si)N nano-multilayer was deposited. In the deposition cathodic arc evaporation was used in the same Hauzer HTC1000 equipment mentioned above.

For the deposition of the (Ti,Al)N-(Ti,Si)N nano-multilayer, two TiAl-targets were used together with one TiSi-target in the PVD reactor. For the TiAl targets the Ti:Al atomic ratio was Ti:Al = 60:40 and for the TiSi targets the Ti:Si atomic ratio was Ti:Si = 85:15.

If reference is herein made to a target of a particular composition, this means that, due to the layout of the used PVD reactor, a line of four targets of the same composition were vertically arranged to allow for a homogeneous deposition throughout the height of the reactor.

The targets had a diameter of 100 mm. The reactive gas for the nitride deposition was $N_2$. The deposition was carried out at an arc current at the target of about 150 A, a bias level of - 40 V at a $N_2$ pressure of 10 Pa, and a t a temperature of 550°C. The table rotation speed in the PVD reactor was set to 3 rpm.

A (Ti,Al)N-(Ti,Si)N nano-multilayer of a thickness of about 4 $\mu$m was deposited. The average layer thickness of the (Ti,Al)N sub-layers was estimated to be about 2-3 nm and the average layer thickness of (Ti,Si)N sub-layers was estimated to be about 2-3 nm.

The sample made is denoted "Sample 2 (comparative)".

Example 3: **Manufacturing of** "Sample 3 (comparative)"

(Monolayer of (Ti,Si)N)

As a substrate was used cutting tool bodies (called "blanks") being inserts having a geometry SPHT120408 (milling insert), and flat inserts for analysis of coating.

The cutting tool body was for the geometry SPHT120408 made out of a cemented carbide of the composition 90.6 wt% WC, 1.4 wt% (Ta, Nb)C and a binder phase of 8 wt% Co. The average WC grain size dWC was 0.8 $\mu$m.

The cutting tool body was for the flat inserts for analysis made out of a cemented carbide of the composition 94 wt% WC, and a binder phase of 6 wt% Co.

Prior to the deposition, the substrate bodies were pretreated by ultrasonic cleaning in a water-based medium.

The PVD reactor was evacuated to $8 \times 10^{-5}$ mbar, and the substrate was pre-treated at 550°C. The pre-treatment included an Ar ion etching procedure.

The coating equipment used for depositing the coating according to the invention was a Hauzer HTC1000 (IHI Hauzer Techno Coating B.V., The Netherlands) with a chamber size of 1 $m^3$.

An innermost, about 10-20 nm, $Ti_{0.40}Al_{0.60}N$ adhesion layer was at first deposited. In the deposition cathodic arc evaporation was used. In the Hauzer HTC1000 equipment used a circular Arc-PVD technology (CARC+) using constant magnetic field configuration was applied during deposition. A TiAl-target "Ti40Al60" (Ti:Al = 40:60) was used. The target had a diameter of 100 mm. The reactive gas for the nitride deposition was $N_2$. The deposition was carried out at an arc current at the target of about 150 A, a bias level of -40 V and at a $N_2$ pressure of 10 Pa. The temperature during the deposition was about 550°C. A table rotation speed of 3 rpm was used.

Then, a (Ti,Si)N layer was deposited. In the deposition cathodic arc evaporation was used in the same Hauzer HTC1000 equipment mentioned above.

For the deposition of the (Ti,Si)N layer, a TiSi-target was used in the PVD reactor and the Ti:Si atomic ratio was Ti:Si = 85:15.

If reference is herein made to a target of a particular composition, this means that, due to the layout of the used PVD reactor, a line of four targets of the same composition were vertically arranged to allow for a homogeneous deposition throughout the height of the reactor.

The target had a diameter of 100 mm. The reactive gas for the nitride deposition was $N_2$. The deposition was carried out at an arc current at the target of about 150 A, a bias level of -40 V at a $N_2$ pressure of 10 Pa, and at a temperature of 550°C. The table rotation speed in the PVD reactor was set to 3 rpm.

A (Ti,Si)N layer of a thickness of about 4 $\mu$m was deposited.

The sample made is denoted "Sample 3 (comparative)".

**Example 4: Manufacturing of "Sample 4 (comparative)"**

A comparative coated cutting tool, essentially according to prior art US 8,709,583 with a top layer of metallic Al + gamma-$Al_2O_3$ according to US 8,858,666, was made by depositing a coating onto a cutting tool body being an insert having a geometry SX-3E300N02-CE4 (parting and grooving insert). The cutting tool body was made out of a cemented carbide of the composition 90.6 wt% WC, 1.4 wt% (Ta, Nb)C and a binder phase of 8 wt% Co. The average WC grain size dWC was 0.8 $\mu$m.

This comparative cutting tool represents a cutting tool known to perform very well in a parting and grooving metal machining operation.

The coating was made out of a 7-layer coating:

1. (Ti,Al)N (ratio Ti:Al of 33:67 atomic %) of a layer thickness of 3 $\mu$m deposited by arc evaporation,
2. gamma-aluminium oxide of a layer thickness of 0.6 $\mu$m deposited by reactive magnetron sputtering,
3. (Ti,Al)N (ratio Ti:Al of 33:67 atomic %) of a layer thickness of 0.3 $\mu$m deposited by arc evaporation,
4. gamma-aluminium oxide of a layer thickness of 0.1 $\mu$m deposited by reactive magnetron sputtering,
5. (Ti,Al)N (ratio Ti:Al of 33:67 atomic %) of a layer thickness of 0.3 $\mu$m deposited by arc evaporation,
6. gamma-aluminium oxide of a layer thickness of 0.1 $\mu$m deposited by reactive magnetron sputtering,
7. A thin metallic Al layer followed by a thin gamma-aluminium oxide layer of a total thickness of 0.1 $\mu$m deposited by reactive magnetron sputtering,

Before the coating operation the substrate was cleaned in alcohol and additionally cleaned by using an Ar ion bombardment prior to deposition of the layers in the vacuum chamber.

Table 4 summarises the layer sequence.

Table 4.

| Layer # (from substrate) | Layer Thickness] | Layers |
|---|---|---|
| 1 | 3 $\mu$m | $Ti_{0.33}Al_{0.67}N$, single layer |
| 2 | 0.6 $\mu$m | gamma-$Al_2O_3$ |
| 3 | 0.3 $\mu$m | $Ti_{0.33}Al_{0.67}N$, single layer |
| 4 | 0.1 $\mu$m | gamma-$Al_2O_3$ |
| 5 | 0.3 $\mu$m | $Ti_{0.33}Al_{0.67}N$, single layer |
| 6 | 0.1 $\mu$m | gamma-$Al_2O_3$ |
| 7 | 0.1 $\mu$m | Al + gamma-$Al_2O_3$ |

The sample made is denoted "Sample 4 (comparative)".

## Example 5: Manufacturing of "Sample 5 (comparative)"

A comparative coated cutting tool, essentially according to prior art US 2023/0033516 A1, was made by depositing a coating onto a cutting tool body being an insert having a geometry SPHT120408 (milling insert). The cutting tool body was made out of a cemented carbide of the composition 90.6 wt% WC, 1.4 wt% (Ta, Nb)C and a binder phase of 8 wt% Co. The average WC grain size dWC was 0.8 $\mu$m.

The essential difference between the coating of "Sample 5 (comparative)" and the coating of "Sample 1 - invention" of Example 1 herein is essentially that all gamma-$Al_2O_3$ layers in the layer sequence of the prior art coating of "Sample 5 (comparative)" have been exchanged into (Ti,Si)N layers.

The total thickness of "Sample 5 (comparative)" was about 5.5 $\mu$m.

The layer structure provided in "Sample 5 (comparative)" is seen in table 5.

Table 5.

| Layer # (from substrate) | Layer Thickness | Layer | (Ti,Al)N sublayer composition |
|---|---|---|---|
| 1 | 4 $\mu$m | first (Ti,Al)N (nano-multilayer) | $Ti_{0.33}Al_{0.67}N$/ $Ti_{0.50}Al_{0.50}N$ (two different stacks L1 and L2) |
| 2 | 0.6 $\mu$m | gamma-$Al_2O_3$ | - |
| 3 | 0.1 $\mu$m | second (Ti,Al)N nano-multilayer | $Ti_{0.33}Al_{0.67}N$/ $Ti_{0.50}Al_{0.50}N$ (as L2) |

(continued)

| Layer # (from substrate) | Layer Thickness | Layer | (Ti,Al)N sublayer composition |
|---|---|---|---|
| 4 | 0.1 $\mu$m | gamma-$Al_2O_3$ | - |
| 5 | 0.1 $\mu$m | second (Ti,Al)N nano-multilayer | $Ti_{0.33}Al_{0.67}N$/ $Ti_{0.50}Al_{0.50}N$ (as L2) |
| 6 | 0.1 $\mu$m | gamma-$Al_2O_3$ | - |
| 7 | 0.3 $\mu$m | second (Ti,Al)N (nano-multilayer) | $Ti_{0.33}Al_{0.67}N$/ $Ti_{0.50}Al_{0.50}N$ (as L2) |
| 8 | 0.2 $\mu$m | ZrN | - |

**Example 6 - Analysis**

The hardness and plane strain modulus were determined for samples "Sample 1 (invention)", "Sample 2 (comparative)" and "Sample 3 (comparative)", according to the methods herein described. A first measurement was made at room temperature. A second measurement was made after 1 hour heat treatment at 800°C. Table 6 shows the results.

Table 6.

| Sample | Hardness [HV0.0015], room temp. | Hardness [HV0.0015], 1 hour, 800°C | Plane strain modulus [MPa], room temp. | Plane strain modulus [MPa], 1 hour, 800°C |
|---|---|---|---|---|
| Sample 1 (invention) | 3068 | 2869 | 509 | 542 |
| Sample 2 (comparative) | 3414 | 2354 | 509 | 432 |
| Sample 3 (comparative) | 3586 | 3514 | 505 | 512 |

It is concluded that the nanolayered (Ti,Al)N/(Ti,Si)N coating (Sample 2) gets much worse mechanical properties after heat treatment while the coating of the invention (Sample 1) substantially keeps its properties behaving similar to a monolayered heat stable (Ti,Si)N coating (Sample 3).

The residual stress as measured by X-ray diffraction applying the $\sin^2\Psi$ method based on the (1 1 1) reflection of (Ti,Si)N was determined for samples "Sample 1 (invention)" and "Sample 3 (comparative)". For "Sample 2 (comparative)", being a nano-layered (Ti,Al)N/(Ti,Si)N with an overall (Ti,Al,Si)N solid solution character, the (1 1 1) reflection of (Ti,Al,Si)N was used. Table 7 shows the results.

Table 7.

| Sample | Residual stress [MPa], TiSiN 111 | Residual stress [MPa], TiAlSiN 111 |
|---|---|---|
| Sample 1 (invention) | -1797 | |
| Sample 2 (comparative) | | -2033 |
| Sample 3 (comparative) | -4157 | |

The "minus"-sign means that the residual stress is compressive, as is usual for PVD coatings. However, it is concluded that the coating of the invention (Sample 1) has a quite low level of residual compressive stress. A low residual compressive stress at the comparatively large coating thickness of Sample 1 is beneficial against flaking of the coating.

Transmission electron microscopy (TEM) analysis revealed that in all (Ti,Si)N layers in the set of alternating (Ti,Al)N layers and (Ti,Si)N layers in the coating of "Sample 1 (invention)" there were crystal lattice planes going through the whole of the (Ti,Si)N layers.

A solid solution phase gives rise to a pattern of peaks in an XRD diffractogram. If one looks at the cubic (200) peak of $(Ti_{0.85}Si_{0.15})N$, which is a solid solution phase, it has a peak located at about 42.8 degrees 2theta. If one looks at the cubic (200) peak of nano-layered $Ti_{0.60}Al_{0.40}N$ - $Ti_{0.85}Si_{0.15}N$, it has also a single (200) peak, which indicates a solid solution phase, located at about 43.2 degrees 2theta. However, if one looks at the (200) peak of a coating comprising alternating layers of $Ti_{0.60}Al_{0.40}N$ and $Ti_{0.85}Si_{0.15}N$ as in the present invention, one sees a broad peak which comprises two maxima, one at about 42.9 degrees 2theta and one at about 43.7 degrees 2theta. The two maxima are considered to represent a first solid solution phase as present in the (Ti,Al)N sublayer and a second solid solution phase as present in the (Ti,Si)N sublayer. If further analysing the broad combined (200) peak by using curve fitting software, such as HighScore Plus by Malvern Panalytical B.V., doing a curve fitting into three peaks gives a quite high fit quality. Apart from two large peaks at about 42.7 and 43.7 degrees 2theta a peak with lower intensity is seen at about 43.3 degrees 2theta. This peak is concluded to arise from a solid solution cubic (Ti,Al,Si)N phase present in a low volume amount in between the (Ti,Al)N sublayer and the (Ti,Si)N sublayer.

Scanning transmission electron microscopy (STEM) analysis in combination with energy-dispersive X-ray spectroscopy (EDX) and also electron energy loss spectroscopy (EELS) revealed that there was a transition region between the (Ti,Al)N and (Ti,Si)N sublayer in the set of alternating (Ti,Al)N layers and (Ti,Si)N layers, which had a thickness of about 7 nm. The conclusion from EELS analysis was that the different peak shape ranging about 7 nm in between the (Ti,Al)N and (Ti,Si)N sublayers could be assigned to a cubic solid solution phase of (Ti,Al,Si)N. The average content was estimated through EDX data to be about 89 at% Ti, 6 at% Al and 5 at% Si.

## Example 7 - Cutting tests

Test 1:

The metal cutting performance of the coated cutting tool samples

"Sample 1 (invention)", "Sample 2 (comparative)", nano-layered $Ti_{0.40}Al_{0.60}N/Ti_{0.85}Si_{0.15}N$, "Sample 3 (comparative)", $Ti_{0.85}Si_{0.15}N$ monolayer, and "Sample 5 (comparative)", were tested in face milling operations using a face milling cutter, on a DMC1850V machine under the following conditions.

Cutting conditions:

| | |
|---|---|
| Insert geometry | SPHT120408 |
| Tooth feed $f_z$ [mm/tooth]: | 0.2 |
| Cutting speed $v_c$ [m/min]: | 160 |
| Radial cutting depth $a_e$ [mm]: | 3 |
| No. teeth z: | 1 |
| Workpiece material: | Steel, 42CrMo4; tensile strength Rm: 800 N/mm$^2$ |

The amount of wear at the cutting edge was determined.

Table 8 shows the results of the cutting tests. Three test runs were performed. The results are presented as normalised to the results of "Sample 5 (comparative)" which results are set to 0 for each test run.

"+" means better performance than "Sample 5 (comparative)".

"++" means much better performance than "Sample 5 (comparative)".

"-" means worse performance than "Sample 5 (comparative)".

"--" means much worse performance than "Sample 5 (comparative)".

"0" means equal performance to "Sample 5 (comparative)".

Table 8.

| Sample ID | without cooling emulsion Test 1/ Test 2/ Test 3 | with cooling emulsion Test 1/Test 2/Test 3 |
|---|---|---|
| Sample 1 (invention) | ++/ +/ ++ | ++/ +/ ++ |
| Sample 2 (comparative) | +/ +/ 0 | +/ +/ ++ |
| Sample 3 (comparative) | ++/ ++/ no test | -/ --/ -- |
| Sample 5 (comparative) | 0/ 0/ 0 | 0/ 0/ 0 |

It is concluded that "Sample 1 (invention)" outperformed "Sample 5 (comparative)" both in dry machining and in wet machining. Also, "Sample 1 (invention)" shows the most versatile function with excellent results both in cutting operations without cooling liquid and with cooling liquid.

<u>Test 2:</u>

The metal cutting performance of the coated cutting tool samples "Sample 1 (invention)" and "Sample 4 (comparative)" were tested in a turning operation, specifically a grooving operation.

This comparative cutting tool according to Sample 4 represents a cutting tool known in the market to perform very well in a parting and grooving metal machining operation.

| Cutting conditions: | |
| --- | --- |
| Insert geometry: | GX24-2E300N02-CE4 and SX-3E300N02-CE4 |
| Feed rate per revolution fn [mm/rev]: | 0.05 |
| Feed rate vf [mm/min]: | 42.59 |
| Cutting speed $v_c$ [m/min]: | 87.50 |
| No. cuts per workpiece: | 1 |
| Groove width [mm]: | 3.00 |
| Groove depth [mm]: | 28.00 |
| Coolant used: | yes |
| No. teeth z: | 1 |
| Workpiece material: | Stainless steel 316L |
| Workpiece diameter [mm]: | 32.70 |
| Rpm [min$^{-1}$]: | 851.8 |

The cut-off criteria was the maximum wear at the flank faces of the tool, i.e., the deepest crater observed on the flank face of a tool, $V_{Bmax}$, reaching 0.3 mm.

The tool life, as number of pieces made until cut-off criteria reached, was 83 pieces for "Sample 1 (invention)" and 55 pieces for "Sample 4 (comparative)".

## Claims

1. A coated cutting tool (1) consisting of a substrate body (5) and a coating (6), the coating (6) comprises, in the order from the substrate body (5) surface,

   an inner layer of (Ti,Al)N (7) with an average composition $(Ti_{1-v}A_v)N$, $0.35 \leq v \leq 0.75$, suitably $0.45 \leq v \leq 0.67$, preferably $0.55 \leq v \leq 0.65$, wherein

   - the thickness of the inner layer of (Ti,Al)N (7) is from 0.5 to 5 $\mu$m, suitably from 1 to 5 $\mu$m, preferably from 2 to 4 $\mu$m,

   a layer of (Ti,Si)N (8), being $Ti_{1-b}Si_bN$, $0.05 \leq b \leq 0.25$, suitably $0.10 \leq b \leq 0.20$, wherein

   - the thickness of the layer of $Ti_{1-b}Si_bN$ (8) is from 300 nm to 1.5 $\mu$m, suitably from 500 nm to 1.2 $\mu$m,

   a set of alternating (Ti,Al)N layers (9) and (Ti,Si)N layers (10), wherein

   - each of the (Ti,Al)N layers (9) has an average composition $(Ti_{1-x}Al_x)N$, $0.35 \leq x \leq 0.75$, suitably $0.45 \leq x \leq 0.67$, preferably $0.55 \leq x \leq 0.65$, and each of the (Ti,Si)N layers (10) has a composition $Ti_{1-y}Si_yN$, $0.05 \leq y \leq 0.25$, suitably $0.10 \leq y \leq 0.20$,
   - the number each of (Ti,Al)N layers (9) and (Ti,Si)N layers (10) is $\geq 2$,
   - the thickness of each of the (Ti,Al)N layers (9) is from 125 to 250 nm, suitably from 135 to 200 nm,
   - the thickness of each of the (Ti,Si)N layers (10) is from 100 to 200 nm, suitably from 125 to 175 nm,
   - the total thickness of the set of alternating (Ti,Al)N layers (9) and (Ti,Si)N layers (10) is from 0.45 to 2.5 $\mu$m, suitably from 0.5 to 1.75 $\mu$m, preferably from 0.55 to 1 $\mu$m,
   - an outer layer of (Ti,Al)N (11) with an average composition $(Ti_{1-c}Al_c)N$, $0.35 \leq c \leq 0.75$, suitably $0.45 \leq c \leq 0.67$, preferably $0.55 \leq c \leq 0.65$, on top of the set of alternating (Ti,Al)N layers (9) and (Ti,Si)N layers (10), the thickness of this outer layer of (Ti,Al)N (11) is from 250 nm to 2 $\mu$m, suitably from 300 nm to 1 $\mu$m.

2. A coated cutting tool (1) according to claim 1, wherein the inner layer of (Ti,Al)N (7) is a first (Ti,Al)N nano-multilayer of alternating (Ti,Al)N sub-layers, wherein

   - each of the individual (Ti,Al)N sub-layers within the first (Ti,Al)N nano-multilayer has a thickness of from 1 to 25 nm;
   - each of the individual (Ti,Al)N sub-layers within the first (Ti,Al)N nano-multilayer being different in respect of the atomic ratio Ti:Al than an immediately adjacent (Ti,Al)N sub-layer.

3. A coated cutting tool (1) according to claim 2, wherein the first (Ti,Al)N nano-multilayer of alternating (Ti,Al)N sub-layers, is a nano-multilayer of one sub-layer $(Ti_{1-w}Al_w)N$, $0.40 \leq w \leq 0.80$, preferably $0.50 \leq w \leq 0.75$, most preferably $0.60 \leq w \leq 0.70$ and one sub-layer $(Ti_{1-a}Al_a)N$, $0.20 \leq a \leq 0.65$, preferably $0.35 \leq a \leq 0.60$, most preferably $0.45 \leq a \leq 0.55$, the Al content in the sub-layer $(Ti_{1-w}Al_w)N$ is higher than the Al content in the sub-layer $(Ti_{1-a}Al_a)N$.

4. A coated cutting tool (1) according to any one of claims 1-3, wherein the number each of (Ti,Al)N layers (9) and (Ti,Si)N layers (10) within the set of alternating (Ti,Al)N layers (9) and (Ti,Si)N layers (10) is from 2 to 10.

5. A coated cutting tool (1) according to any one of claims 1-4, wherein the (Ti,Al)N layers (9) within the set of alternating (Ti,Al)N layers (9) and (Ti,Si)N layers (10) are each a second (Ti,Al)N nano-multilayer of alternating (Ti,Al)N sub-layers, wherein

   - each of the individual (Ti,Al)N sub-layers within the second (Ti,Al)N nano-multilayer has a thickness of from 1 to 25 nm;
   - each of the individual (Ti,Al)N sub-layers within the second (Ti,Al)N nano-multilayer being different in respect of the atomic ratio Ti:Al than an immediately adjacent (Ti,Al)N sub-layer.

6. A coated cutting tool (1) according to claim 5, wherein the second (Ti,Al)N nano-multilayer of alternating (Ti,Al)N sub-layers, is a nano-multilayer of one sub-layer $(Ti_{1-z}Al_z)N$, $0.40 \leq z \leq 0.80$, preferably $0.50 \leq z \leq 0.75$, most preferably $0.60 \leq z \leq 0.70$ and one sub-layer $(Ti_{1-u}Al_u)N$, $0.20 \leq u \leq 0.65$, preferably $0.35 \leq u \leq 0.60$, most preferably $0.45 \leq u \leq 0.55$, the Al content in the sub-layer $(Ti_{1-z}Al_z)N$ is higher than the Al content in the sub-layer $(Ti_{1-u}Al_u)N$.

7. A coated cutting tool (1) according to any one of claims 1-6, wherein the outer layer of (Ti,Al)N (11) is a third (Ti,Al)N nano-multilayer of alternating (Ti,Al)N sub-layers, wherein

   - each of the individual (Ti,Al)N sub-layers within the third (Ti,Al)N nano-multilayer has a thickness of from 1 to 25 nm;
   - each of the individual (Ti,Al)N sub-layers within the third (Ti,Al)N nano-multilayer being different in respect of the atomic ratio Ti:Al than an immediately adjacent (Ti,Al)N sub-layer, and wherein
   - the third (Ti,Al)N nano-multilayer is a nano-multilayer of one sub-layer $(Ti_{1-d}Al_d)N$, $0.40 \leq d \leq 0.80$, preferably $0.50 \leq d \leq 0.75$, most preferably $0.60 \leq d \leq 0.70$ and one sub-layer $(Ti_{1-e}Al_e)N$, $0.20 \leq e \leq 0.65$, preferably $0.35 \leq e \leq 0.60$, most preferably $0.45 \leq e \leq 0.55$, the Al content in the sub-layer $(Ti_{1-d}Al_d)N$ is higher than the Al content in the sub-layer $(Ti_{1-e}Al_e)N$.

8. A coated cutting tool (1) according to any one of claims 1-7, wherein there is a transition region between each of the (Ti,Al)N layers (9) and the (Ti,Si)N layers (10) in the set of alternating (Ti,Al)N layers (9) and (Ti,Si)N layers (10), which has a thickness of less than 25 nm, preferably from 1 to 20 nm, most preferably from 3 to 15 nm, the transition region comprises a solid solution phase of (Ti,Al,Si)N, the average content of Ti within the transition region is from 85 to 93 at%, the average content of Al within the transition region is from 3 to 10 at%, and the average content of Si within the transition region is from 2 to 12 at%, out of the total of the elements Ti, Al and Si.

9. A coated cutting tool (1) according to any one of claims 1-8, wherein there are crystal lattice planes going through the whole of the (Ti,Si)N layers (10) in the set of alternating (Ti,Al)N layers (9) and (Ti,Si)N layers (10).

10. A coated cutting tool (1) according to any one of claims 1-9, wherein the coating (6) has a Vickers hardness of > 3000 HV0.0015, or > 3100 HV0.0015 but < 3800 HV0.0015, or > 3200 HV0.0015 but < 3600 HV0.0015.

11. A coated cutting tool (1) according to any one of claims 1-10, wherein the coating (6) has a plane strain modulus of > 475 GPa, preferably > 485 GPa but < 530 GPa, most preferably > 495 GPa but < 520 GPa.

**12.** A coated cutting tool (1) according to any one of claims 1-11, wherein within the coating (6) there is a residual compressive stress, as measured by X-ray diffraction applying the $\sin^2\Psi$ method based on the (1 1 1) reflection of (Ti,Si)N, of > 1 GPa but < 3 GPa, preferably > 1.3 GPa but < 2.5 GPa, most preferably > 1.5 GPa but < 2 GPa.

**13.** A coated cutting tool (1) according to any one of claims 1-12, wherein the total thickness of the coating (6) is from 3 to 10 μm.

**14.** A coated cutting tool (1) according to any one of claims 1-13, wherein the substrate body (5) is of a cemented carbide, a cermet, a cubic boron nitride, a ceramic, or a high-speed steel, preferably a cemented carbide.

**15.** A coated cutting tool (1) according to any one of claims 1-14, wherein the cutting tool (1) is a cutting insert for milling, a cutting insert for turning, a cutting insert for drilling, a drill or an endmill.

FIG. 1

FIG. 2

FIG. 3

Europäisches Patentamt

European Patent Office

Office européen des brevets

# EUROPEAN SEARCH REPORT

Application Number

EP 23 19 2670

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 7 923 130 B2 (SUMITOMO ELEC HARDMETAL CORP [JP]) 12 April 2011 (2011-04-12)<br>* column 6, lines 59-65; table 1 *<br>* column 10 *<br>----- | 1-15 | INV.<br>C23C28/04<br>C23C28/00<br>C23C30/00 |
| A | WO 2023/041415 A1 (SANDVIK COROMANT AB [SE]) 23 March 2023 (2023-03-23)<br>* the whole document *<br>----- | 1-15 | |
| A | US 2012/114436 A1 (ANDERSSON JON [SE] ET AL) 10 May 2012 (2012-05-10)<br>* the whole document *<br>----- | 1-15 | |
| A | US 2014/147683 A1 (ARNDT MIRJAM [CH]) 29 May 2014 (2014-05-29)<br>* the whole document *<br>----- | 1-15 | |

| | | TECHNICAL FIELDS SEARCHED (IPC) |
|---|---|---|
| | | C23C |

The present search report has been drawn up for all claims

| Place of search | Date of completion of the search | Examiner |
|---|---|---|
| The Hague | 5 February 2024 | Martinavicius, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 2670

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2024

| Patent document cited in search report | | Publication date | Patent family member(s) | | Publication date |
|---|---|---|---|---|---|
| US 7923130 | B2 | 12-04-2011 | AT | E520489 T1 | 15-09-2011 |
| | | | CN | 101678466 A | 24-03-2010 |
| | | | EP | 2156912 A1 | 24-02-2010 |
| | | | JP | 4576638 B2 | 10-11-2010 |
| | | | JP | WO2008146727 A1 | 19-08-2010 |
| | | | KR | 20100007925 A | 22-01-2010 |
| | | | US | 2010215951 A1 | 26-08-2010 |
| | | | WO | 2008146727 A1 | 04-12-2008 |
| WO 2023041415 | A1 | 23-03-2023 | EP | 4151769 A1 | 22-03-2023 |
| | | | WO | 2023041415 A1 | 23-03-2023 |
| US 2012114436 | A1 | 10-05-2012 | CN | 102449194 A | 09-05-2012 |
| | | | EP | 2438209 A1 | 11-04-2012 |
| | | | JP | 2012528732 A | 15-11-2012 |
| | | | KR | 20120015338 A | 21-02-2012 |
| | | | SE | 0900739 A1 | 02-12-2010 |
| | | | US | 2012114436 A1 | 10-05-2012 |
| | | | WO | 2010140958 A1 | 09-12-2010 |
| US 2014147683 | A1 | 29-05-2014 | AR | 086812 A1 | 22-01-2014 |
| | | | BR | 112013033654 A2 | 01-03-2017 |
| | | | CA | 2840536 A1 | 03-01-2013 |
| | | | CN | 103764873 A | 30-04-2014 |
| | | | EP | 2726648 A1 | 07-05-2014 |
| | | | ES | 2763959 T3 | 01-06-2020 |
| | | | HU | E047421 T2 | 28-04-2020 |
| | | | JP | 6236601 B2 | 29-11-2017 |
| | | | JP | 2014523968 A | 18-09-2014 |
| | | | KR | 20140047688 A | 22-04-2014 |
| | | | MX | 347702 B | 09-05-2017 |
| | | | PL | 2726648 T3 | 31-03-2020 |
| | | | RU | 2014102998 A | 10-08-2015 |
| | | | US | 2014147683 A1 | 29-05-2014 |
| | | | WO | 2013000557 A1 | 03-01-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8709583 B
- US 8858666 B
- US 20230033516 A1

**Non-patent literature cited in the description**

- **ROEBUCK et al.** Measurement Good Practice No. 20. National Physical Laboratory, November 1999, 19-20
- **M.E. FITZPATRICK** ; **A.T. FRY** ; **P. HOLDWAY** ; **F.A. KANDIL** ; **J. SHACKLETON** ; **L. SUOMINEN**. Determination of Residual Stresses by X-ray Diffraction - Issue 2. *A Measurement Good Practice Guide No. 52*, 2005